# DEMANDE DE BREVET EUROPEEN

(11) **EP 4 345 576 A1**
(43) Date de publication de la demande: **03.04.2024**
(21) Numéro de dépôt: 22306438.7
(22) Date de dépôt: 28.09.2022
(51) Int. Cl.: G06F 1/20, G02B 6/42, H05K 7/20

(54) **DISSIPATEUR THERMIQUE POUR CONNECTEUR ACTIF DE LAME DE CALCUL**

(71) Demandeur: BULL SAS, 78340 Les Clayes-Sous-Bois (FR)
(72) Inventeur: LAMY, Pierre, 75014 Paris (FR); BERQUIER, ROMAIN, 78340 Les Clayes-sous-Bois (FR)
(74) Mandataire: Argyma

(57) **Abrégé**

Dissipateur thermique (1) à refroidissement liquide pour une pluralité de connecteurs de lame de calcul, comprenant un corps (10) de forme allongée définissant sur l'une de ses faces une surface (11) de collecte de chaleur de la pluralité de connecteurs, ladite surface (11) comprenant une pluralité de zones d'interfaçage (11A) disposées consécutivement le long de la surface (11), chaque zone d'interfaçage (11A) étant configurée pour s'interfacer avec un connecteur de la pluralité de connecteurs afin d'en collecter la chaleur, le dissipateur thermique (1) comprenant au moins un raidisseur (20) monté sur le corps (10).

## Description

### [Domaine technique]

La présente invention se rapporte au domaine du refroidissement des connecteurs actifs de lame de calcul et concerne plus particulièrement un dissipateur thermique à refroidissement liquide pour connecteur actif de lame de calcul et son procédé de fabrication.

### [Etat de la technique antérieure]

Dans les lames de calcul pour serveur, notamment pour supercalculateur, il est connu d'utiliser des connecteurs pour interconnecter une ou plusieurs cartes électroniques de la lame de calcul à un réseau de communication externe à la lame de calcul.

Ces connecteurs sont dits « actifs » car ils intègrent des composants électroniques actifs permettant la ré-amplification des signaux afin de permettre l'échange de données entre la lame de calcul et l'extérieur en conservant l'intégrité des liens hautes vitesse, par exemple avec une autre lame de calcul ou un serveur via un réseau de communication.

Les connecteurs actifs présentent une capacité thermique importante, c'est-à-dire qu'ils dégagent une quantité importante de chaleur, et doivent donc être refroidis.

Parmi les connecteurs actifs pour lames de calcul, on distingue les connecteurs de type Quad Small Form-factor Pluggable (QSFP) et les connecteurs de type Octal Small Form Factor Pluggable (OSFP), qui constitue la génération postérieure à celle des connecteurs QSFP.

Les connecteurs QSFP présentent une capacité thermique allant généralement jusqu'à 8W tandis que les connecteurs OSFP présentent une capacité thermique allant généralement jusqu'à 18W.

Les connecteurs OSFP n'ayant fait leur apparition sur le marché que récemment, les solutions existantes de refroidissement de connecteurs actifs ont été principalement développées pour le refroidissement de la génération de connecteurs QSFP.

Ainsi, les solutions de refroidissement pour les connecteurs actifs sont généralement prévues pour des groupes réduits de connecteurs, typiquement de quatre ou cinq connecteurs. En outre, la ou les cartes électroniques de la lame de calcul doivent disposer du nombre de points de fixation nécessaires pour monter le dissipateur thermique au-dessus du groupe de connecteurs.

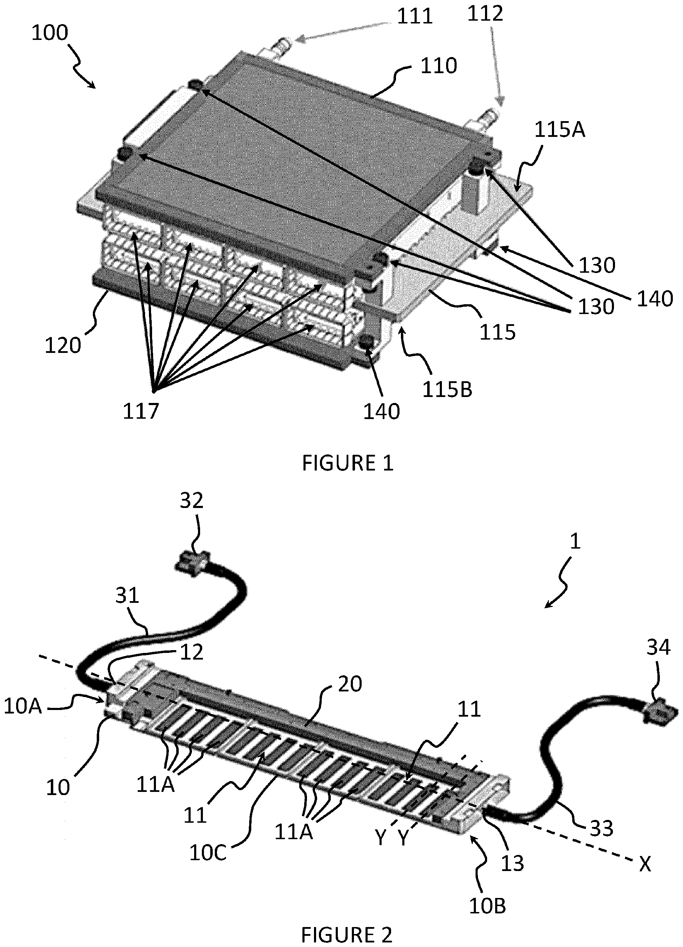

A titre d'exemple, en référence à la figure 1, la lame de calcul 100 comporte un premier dissipateur thermique 110 permettant de refroidir une première face 115A d'une carte électronique 115 comportant quatre connecteurs 117 et un deuxième dissipateur thermique 120 permettant de refroidir une deuxième face 115B de la carte électronique 115, comportant également quatre connecteurs 117. Le premier dissipateur thermique 110 est fixés sur la carte électronique 115 via quatre points de fixation 130 et présente une entrée hydraulique 111 et une sortie hydraulique 112. Le deuxième dissipateur thermique 120 est fixés sur la carte électronique 115 via quatre points de fixation 140 (dont deux seulement sont visibles sur la figure 1) et présente une entrée hydraulique et une sortie hydraulique (non visibles sur la figure 1).

Les solutions existantes présentent ainsi plusieurs inconvénients. Tout d'abord, de nombreux points de fixation sur la ou les cartes électroniques sont nécessaires, ce qui complexifie la fabrication et l'agencement de la lame de calcul. Ensuite, dans certaines lames de calculs, des ensembles de seize connecteurs de type OSFP doivent pouvoir être utilisés, ce qui nécessiterait quatre dissipateurs thermiques avec les agencements des solutions actuelles et paraîtrait complexe voire impossible à mettre en oeuvre, tout en augmentant le nombre de tuyaux de raccordements hydrauliques nécessaires de manière difficilement gérable en termes de branchement et d'espace. Les solutions existantes impliquent également un manque de compacité de la lame de calcul, notamment du fait des nombreux tuyaux et points de fixation nécessaires. Enfin, les solutions existantes ne sont pas suffisamment performantes thermiquement pour le refroidissement des connecteurs actifs de forte capacité thermique, notamment de type OSFP.

Il s'avérerait donc avantageux de proposer une solution simple, fiable et efficace permettant de remédier au moins en partie à ces inconvénients.

### [Exposé de l'invention]

A cette fin, l'invention a pour objet un dissipateur thermique à refroidissement liquide pour une pluralité de connecteurs de lame de calcul, ledit dissipateur thermique comprenant un corps de forme allongée définissant sur l'une de ses faces une surface de collecte de chaleur de la pluralité de connecteurs, ledit corps comprenant un port d'entrée de liquide réfrigérant et un port de sortie de liquide réfrigérant et étant configuré pour acheminer le liquide réfrigérant à travers un circuit de refroidissement entre ledit port d'entrée et ledit port de sortie, ladite surface de collecte de chaleur comprenant une pluralité de zones d'interfaçage disposées consécutivement le long de la surface de collecte de chaleur, chaque zone d'interfaçage étant configurée pour s'interfacer avec un connecteur de la pluralité de connecteurs afin d'en collecter la chaleur pour la transférer au circuit de refroidissement, le dissipateur thermique comprenant au moins un raidisseur monté sur le corps.

L'au moins un raidisseur permet de rigidifier suffisamment le corps du dissipateur thermique pour que ledit corps dispose d'une surface de collecte de chaleur importante. L'au moins un raidisseur permet notamment d'augmenter le rapport longueur sur largeur du corps pour pouvoir s'interfacer avec un nombre plus important de connecteurs actifs tout en minimisant la hauteur qui est inférieure à 1U (1 unité de rack ou la hauteur normalisée d'un équipement électronique conçu pour être monté dans un rack). En utilisant un corps allongé et au moins un raidisseur, le dissipateur thermique selon l'invention permet de refroidir plus de cinq connecteurs actifs en même temps, notamment jusqu'à au moins seize connecteurs actifs.

Avantageusement, l'au moins un raidisseur est disposé au moins le long d'une partie des zones d'interfaçage afin de les renforcer.

Avantageusement encore, l'au moins un raidisseur est disposé au moins sur toute la longueur des zones d'interfaçage afin de les renforcer davantage.

De préférence, l'au moins un raidisseur est disposé au moins sur toute la longueur de la surface de collecte de chaleur afin de rigidifier l'ensemble de ladite surface.

De préférence encore, l'au moins un raidisseur présente une forme de U s'étendant le long d'un bord longitudinal et des deux bords latéraux du corps afin de rigidifier davantage ledit corps autour de la surface de collecte de chaleur, notamment selon les deux directions orthogonales de longueur et de largeur du corps.

Selon un aspect de l'invention, l'au moins un raidisseur est réalisé en métal, de préférence en acier.

Dans un mode de réalisation, les zones d'interfaçage présentent une forme rectangulaire pour épouser des connecteurs de forme parallélépipédiques, notamment de type OSFP.

Avantageusement, les zones d'interfaçage sont délimitées par un bord du corps afin de limiter la largeur dudit corps.

De préférence, la surface de collecte de chaleur comprend au moins huit zones d'interfaçage, de préférence au moins douze zones d'interfaçage, par exemple seize zones d'interfaçage pour s'interfacer avec au moins seize connecteurs disposés côte à côte.

Dans une forme de réalisation, le port d'entrée est situé au niveau d'une première extrémité du corps et le port de sortie est situé au niveau d'une deuxième extrémité, opposée à la première extrémité, afin de permettre au circuit de refroidissement de traverser le corps et de capter la chaleur efficacement.

De préférence, le corps comprend un unique port d'entrée et un unique port de sortie pour simplifier la création du corps.

Selon un aspect de l'invention, le corps présente une forme globale sensiblement rectangulaire afin de faciliter l'agencement du dissipateur thermique dans une lame de calcul.

De préférence, le rapport de la longueur du corps sur la largeur du corps est supérieur à deux, de préférence à quatre, afin de pouvoir interfacer le dissipateur thermique avec un nombre important de connecteurs, de préférence au moins huit connecteurs, par exemple seize connecteurs.

De préférence, le corps est réalisé en métal, de préférence en aluminium, de préférence encore en aluminium série 6063.

L'invention concerne également une lame de calcul pour supercalculateur comprenant au moins une carte électronique comportant au moins un processeur, une pluralité de connecteurs, de préférence au moins huit connecteurs, par exemple seize connecteurs, et un dissipateur thermique tel que présenté précédemment fixé sur l'au moins une carte électronique de telle sorte que chaque connecteur soit en interface avec l'une des zones d'interfaçage dudit dissipateur thermique.

Dans un mode de réalisation, les connecteurs sont de type émetteur-récepteur.

Selon un aspect de l'invention, les connecteurs sont des connecteurs actifs, c'est-à-dire que les connecteurs sont configurés pour recevoir et émettre des données d'une part sur un lien de communication filaire et d'autre part sur un lien de communication sans-fil.

Selon un aspect de l'invention, les connecteurs sont enfichables et configurés pour être chacun connectés à une carte électronique de la lame de calcul via un câble de communication.

De préférence, les connecteurs sont de type OSFP.

L'invention concerne également un procédé de fabrication d'un dissipateur thermique à refroidissement liquide pour une pluralité de connecteurs de lame de calcul, ledit procédé comprenant les étapes de :
- création, de préférence par usinage, d'un corps de forme allongée définissant sur l'une de ses faces une surface de collecte de chaleur de la pluralité de connecteurs, ledit corps comprenant un port d'entrée de liquide réfrigérant et un port de sortie de liquide réfrigérant et étant configuré pour acheminer le liquide réfrigérant à travers un circuit de refroidissement entre ledit port d'entrée et ledit port de sortie, ladite surface de collecte de chaleur comprenant une pluralité de zones d'interfaçage disposées consécutivement le long de la surface de collecte de chaleur, chaque zone d'interfaçage étant configurée pour s'interfacer avec un connecteur de la pluralité de connecteurs afin d'en collecter la chaleur pour la transférer au circuit de refroidissement,
- création, de préférence par usinage, d'au moins un raidisseur configuré pour être monté sur le corps,
- montage de l'au moins un raidisseur au moins en partie le long du corps.

Dans un mode de réalisation, le raidisseur est monté au moins le long d'une partie des zones d'interfaçage.

Avantageusement, l'au moins un raidisseur est monté au moins sur toute la longueur des zones d'interfaçage.

Avantageusement encore, le raidisseur est monté au moins sur toute la longueur de la surface de collecte de chaleur.

De préférence, l'au moins un raidisseur présente une forme de U et est monté le long d'un bord longitudinal et des deux bords latéraux du corps.

Avantageusement, le raidisseur est réalisé en métal, de préférence en acier.

Dans un mode de réalisation, les zones d'interfaçage présentent une forme rectangulaire.

Avantageusement, les zones d'interfaçage sont délimitées par un bord du corps.

Avantageusement encore, la surface de collecte de chaleur comprend au moins huit zones d'interfaçage, de préférence seize zones d'interfaçage pour s'interfacer avec seize connecteurs disposés côte à côte.

Dans un mode de réalisation, chaque connecteur est configuré pour être connecté à une carte électronique de la lame de calcul via un câble de communication.

Selon un aspect de l'invention, les connecteurs sont des connecteurs actifs, c'est-à-dire que les connecteurs sont configurés pour recevoir et/ou émettre des données.

Dans un mode de réalisation, les connecteurs sont de type émetteur-récepteur, de préférence de type OSFP.

Dans un mode de réalisation, le port d'entrée est situé au niveau d'une première extrémité du corps et le port de sortie est situé au niveau d'une deuxième extrémité, opposée à la première extrémité.

De préférence, le corps comprend un unique port d'entrée et un unique port de sortie.

Avantageusement, le corps présente une forme globale sensiblement rectangulaire.

De préférence, le rapport de la longueur du corps sur la largeur du corps est supérieur à deux, de préférence à quatre.

Selon un aspect de l'invention, le corps est réalisé en métal, de préférence en aluminium, de préférence encore en aluminium série 6063.

### [Description des dessins]

D'autres caractéristiques et avantages de l'invention apparaîtront encore à la lecture de la description qui va suivre. Celle-ci est purement illustrative et doit être lue en regard des dessins annexés sur lesquels :
[Fig 1] La figure 1 illustre schématiquement une forme de réalisation d'un dissipateur thermique de l'art antérieur.
[Fig 2] La figure 2 illustre schématiquement une forme de réalisation du dissipateur thermique selon l'invention.
[Fig 3] La figure 3 est une vue de dessous du dissipateur thermique de la figure 2, c'est-à-dire de la face opposée à la surface de collecte de chaleur, le corps étant montré en transparence.
[Fig 4] La figure 4 est une vue éclatée du dissipateur thermique de la figure 2 montrant notamment le corps et le raidisseur.
[Fig 5] La figure 5 illustre schématiquement un mode de réalisation du procédé de fabrication selon l'invention.

### [Description des modes de réalisation]

La figure 2 illustre un exemple de dissipateur thermique 1 à refroidissement liquide selon l'invention.

Le dissipateur thermique 1 est destiné à être monté dans une lame de calcul de supercalculateur afin de collecter la chaleur générée par des connecteurs actifs de la lame de calcul. Plus précisément, le dissipateur thermique 1 est destiné à être fixé sur une carte électronique de la lame de calcul par l'intermédiaire de fixations en s'interfaçant avec les connecteurs actifs.

Les connecteurs n'ont pas été représentés sur les figures mais s'interfacent de manière standard avec le dissipateur thermique 1. Par le terme « interfacer », il est entendu que le dissipateur thermique vient se placer contre les connecteurs pour collecter la chaleur générée par lesdits connecteurs.

Un faible espace peut être prévu entre le dissipateur thermique 1 et les connecteurs, par exemple moins de 5 mm, mais le dissipateur thermique 1 est de préférence monté au contact physique des connecteurs pour mieux absorber la chaleur générée par lesdits connecteurs. Une interface dissipatrice de type pont thermique (« thermal bridge » en langue anglaise) peut aussi assurer le contact entre le dissipateur thermique 1 et les connecteurs.

### Dissipateur thermique 1

Selon l'invention, le dissipateur thermique 1 comprend un corps 10 et au moins un raidisseur 20. Dans l'exemple illustré sur les figures 2 à 4, le dissipateur thermique 1 comprend un corps 10 et un unique raidisseur 20 afin de simplifier la fabrication et le montage du dissipateur thermique 1. Dans une autre forme de réalisation, le dissipateur thermique 1 pourrait comprend un corps 10 et plusieurs raidisseurs, de formes identiques ou différentes.

### Corps 10

Le corps 10 présente une forme allongée, sensiblement rectangulaire, s'étendant selon un axe longitudinal X. Dans l'exemple illustré sur les figures 2 à 4, le rapport de la longueur du corps 10 sur la largeur du corps 10 est supérieur à quatre pour permettre de refroidir seize connecteurs tout en conservant une largeur de corps 10 légèrement supérieure à la longueur des connecteurs, c'est-à-dire relativement étroite pour améliorer la compacité latérale du dissipateur thermique 1. Le corps 10 est réalisé en métal, de préférence en aluminium, de préférence encore en aluminium série 6063, qui est un type d'aluminium peu onéreux, facile à usiner et notablement résistant. De plus, ce type d'aluminium permet de maximiser la durée de vie du produit par ces propriété de tenue à la corrosion.

Le corps 10 définit sur l'une de ses faces une surface 11 dite « de collecte de chaleur » destinée à s'interfacer avec les connecteurs pour collecter au moins une partie de la chaleur que lesdits connecteurs génèrent.

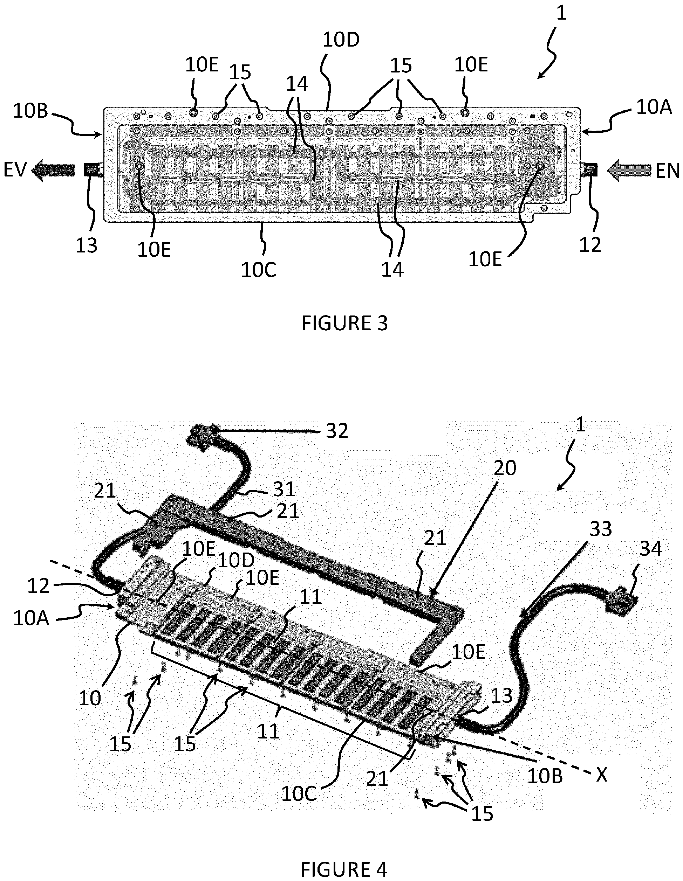

En référence à la figure 3, le corps 10 comprend un port d'entrée 12, un port de sortie 13 et un circuit de refroidissement 14 cheminant sous la surface 11 de collecte de chaleur entre ledit port d'entrée 12 et ledit port de sortie 13.

Le port d'entrée 12 est situé au niveau d'une première extrémité 10A du corps 10 et le port de sortie 13 est situé au niveau d'une deuxième extrémité 10B du corps 10, opposée à la première extrémité 10A.

Toujours référence à la figure 3, le port d'entrée 12 permet l'entrée EN de liquide réfrigérant (non visible) dans le circuit de refroidissement 14. Comme illustré sur la figure 2, le port d'entrée 12 est alimenté en liquide réfrigérant par un module de réfrigération (non représenté sur les figures) via un tuyau d'entrée 31 et un bloc hydraulique d'entrée 32.

En référence aux figures 2 et 3, le port de sortie 13 permet l'évacuation EV du liquide réfrigérant hors du corps 10 vers le module de réfrigération afin de le régénérer via un tuyau de sortie 33 et un bloc hydraulique de sortie 34.

Le circuit de refroidissement 14 chemine à travers le corps 10 sous la surface 11 de collecte de chaleur de sorte à couvrir une large superficie de ladite surface 11 et collecter ainsi une large quantité de la chaleur générée par les connecteurs.

La surface 11 de collecte de chaleur présente une forme rectangulaire en s'étendant dans une direction parallèle à l'axe longitudinal X.

La surface 11 comprend une pluralité de zones distinctes dites « d'interfaçage » 11A.

En référence à la figure 2, les zones d'interfaçage 11A présentent une forme rectangulaire et sont disposées consécutivement le long de ladite surface 11 de collecte de chaleur, c'est-à-dire entre ses deux extrémités, l'axe longitudinal Y de chaque zone d'interfaçage 11A s'étend orthogonalement à l'axe longitudinal de la surface de collecte de chaleur, c'est-à-dire orthogonalement à l'axe longitudinal X du corps. Sur la figure 2, seuls deux axes longitudinaux Y ont été représentés par souci de clarté.

Chaque zone d'interfaçage 11A est configurée pour s'interfacer avec un connecteur de la pluralité de connecteurs afin d'en collecter une partie de la chaleur pour la transférer au circuit de refroidissement 14.

Dans l'exemple des figures 2 à 4, la surface 11 de collecte de chaleur comprend seize zones d'interfaçage 11A, permettant au dissipateur thermique 1 de refroidir seize connecteurs simultanément. Dans cet exemple, mais de manière non limitative, les zones d'interfaçage 11A sont délimitées par un bord 10C du corps 10 afin d'optimiser la largeur dudit corps 10, le bord 10D opposé du corps 10 (visible sur la figure 3) recevant le raidisseur 20.

Dans cet exemple, le corps 10 comprend quatre orifices 10E permettant de recevoir des vis de fixation du dissipateur thermique 1 sur une carte électronique d'une lame de calcul.

### Raidisseur 20

Le raidisseur 20 est monté sur le corps 10 afin de le renforcer pour éviter qu'il ne se déforme.

Dans l'exemple illustré sur les figures 2 à 4, le raidisseur 20 présente sensiblement une forme de U en s'étendant à la fois le long d'un bord 10D longitudinal du corps 10, sur plus de quatre-cinquième de la longueur dudit corps 10 dans cet exemple pour un renfort efficace, et sur toute la largeur du corps 10 à la fois au niveau de la première extrémité 10A et de la deuxième extrémité 10B du corps 10.

Le raidisseur 20 peut avantageusement être réalisé en métal, de préférence en acier.

Le raidisseur 20 est monté sur le corps 10 au moyen d'une pluralité de vis 15 (figures 3 et 4).

Dans cet exemple, le raidisseur 20 comprend en outre quatre orifices 21, superposés avec les orifices 10E du corps 10, permettant de recevoir des vis de fixation du dissipateur thermique 1 sur une carte électronique d'une lame de calcul.

### Connecteurs

Dans un mode de réalisation, les connecteurs sont actifs de type émetteur-récepteur, c'est-à-dire que les connecteurs sont configurés pour recevoir et émettre des signaux comportant des données.

Dans l'exemple des figures 2 à 4, les zones d'interfaçage 11A sont adaptées pour recevoir des connecteurs de type OSFP.

Les connecteurs sont enfichables et configurés pour être chacun connectés à une carte électronique de la lame de calcul via un câble de communication.

Les connecteurs sont également configurés pour communiquer avec un réseau de communication externe (non représenté) sur un lien de communication sans fil.

Il va de soit que dans une autre forme de réalisation, le dissipateur thermique 1 pourrait être adapté pour recevoir d'autres types de connecteurs, du moment qu'il dégage une quantité de chaleur à évacuer.

### Exemple de fabrication

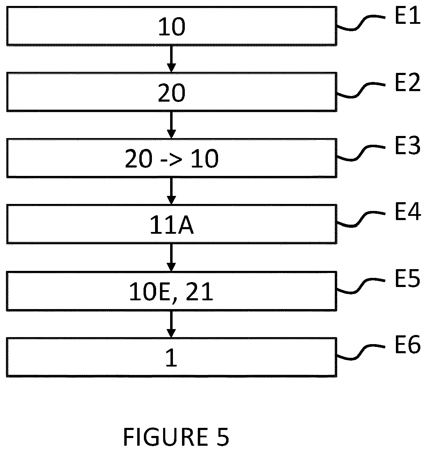

En référence à la figure 5, dans une étape E1, le corps 10 est tout d'abord formé, de préférence par usinage, de préférence dans de l'aluminium série 6063, de sorte à former notamment la surface 11 de collecte de chaleur, le port d'entrée 12, le port de sortie 13 et le circuit de refroidissement 14.

En parallèle, dans une étape E2, le raidisseur 20 est formé, de préférence par usinage dans de l'acier.

Ensuite, dans une étape E3, en référence à la figure 4, le raidisseur en U est monté sur le corps 10 à l'aide de vis 15 de sorte à entourer la surface 11 de collecte de chaleur sur trois côtés et rigidifier ainsi le corps 10 de manière à supporter l'interfaçage de seize connecteurs avec les zones d'interfaçage 11A.

Dans une étape E4, le dissipateur thermique 1 peut être placé de sorte que les zones d'interfaçage 11A viennent recouvrir les connecteurs d'une lame de calcul (non représentée) puis fixé dans une étape E5 sur l'une cartes électroniques de la lame de calcul à l'aide de fixations, de préférence quatre fixations ou moins. Ces fixations peuvent être des vis fixées à travers des orifices 10E et 21 dédiés formés respectivement dans le corps 10 et dans le raidisseur 20, comme illustré sur les figures 3 et 4.

Dans une étape E6, la lame de calcul peut être placée dans un supercalculateur et le dissipateur thermique 1 relié à un module de réfrigération configuré pour l'approvisionner en liquide réfrigérant et permettre ainsi le refroidissement des connecteurs.

L'invention présente ainsi l'avantage de pouvoir interfacer un unique dissipateur thermique avec plus de quatre ou cinq connecteurs, notamment avec seize connecteurs, tout en gardant une compacité, une efficacité et une solidité significatives.

## Revendications

1. Dissipateur thermique (1) à refroidissement liquide pour une pluralité de connecteurs de lame de calcul, ledit dissipateur thermique (1) comprenant un corps (10) de forme allongée définissant sur l'une de ses faces une surface (11) de collecte de chaleur de la pluralité de connecteurs, ledit corps (10) comprenant un port d'entrée (12) de liquide réfrigérant et un port de sortie (13) de liquide réfrigérant et étant configuré pour acheminer le liquide réfrigérant à travers un circuit de refroidissement (14) entre ledit port d'entrée (12) et ledit port de sortie (13), ladite surface (11) de collecte de chaleur comprenant une pluralité de zones d'interfaçage (11A) disposées consécutivement le long de la surface (11) de collecte de chaleur, chaque zone d'interfaçage (11A) étant configurée pour s'interfacer avec un connecteur de la pluralité de connecteurs afin d'en collecter la chaleur pour la transférer au circuit de refroidissement (14), le dissipateur thermique (1) comprenant au moins un raidisseur (20) monté sur le corps (10).

2. Dissipateur thermique (1) selon la revendication 1, dans lequel l'au moins un raidisseur (20) est disposé au moins le long d'une partie des zones d'interfaçage (11A).

3. Dissipateur thermique (1) selon l'une quelconque des revendications précédentes, dans lequel l'au moins un raidisseur (20) est disposé au moins sur toute la longueur des zones d'interfaçage (11A).

4. Dissipateur thermique (1) selon l'une quelconque des revendications précédentes, dans lequel l'au moins un raidisseur (20) est disposé au moins sur toute la longueur de la surface (11) de collecte de chaleur

5. Dissipateur thermique (1) selon l'une quelconque des revendications précédentes, dans lequel l'au moins un raidisseur (20) présente une forme de U s'étendant le long d'un bord longitudinal (10D) et des deux bords latéraux du corps (10).

6. Dissipateur thermique (1) selon l'une quelconque des revendications précédentes, dans lequel l'au moins un raidisseur (20) est réalisé en métal, de préférence en acier.

7. Dissipateur thermique (1) selon l'une quelconque des revendications précédentes, dans lequel les zones d'interfaçage (11A) sont délimitées par un bord (10C) du corps (10).

8. Dissipateur thermique (1) selon l'une quelconque des revendications précédentes, dans lequel la surface (11) de collecte de chaleur comprend au moins huit zones d'interfaçage (11A), de préférence seize zones d'interfaçage (11A).

9. Dissipateur thermique (1) selon l'une quelconque des revendications précédentes, dans lequel le port d'entrée (12) est situé au niveau d'une première extrémité (10A) du corps (10) et le port de sortie (13) est situé au niveau d'une deuxième extrémité (10B), opposée à la première extrémité (10A).

10. Dissipateur thermique (1) selon l'une quelconque des revendications précédentes, dans lequel le corps (10) présente une forme globale sensiblement rectangulaire.

11. Dissipateur thermique (1) selon l'une quelconque des revendications précédentes, dans lequel le rapport de la longueur du corps (10) sur la largeur du corps (10) est supérieur à deux, de préférence à quatre.

12. Dissipateur thermique (1) selon l'une quelconque des revendications précédentes, dans lequel le corps (10) est réalisé en métal, de préférence en aluminium, de préférence encore en aluminium série 6063.

13. Lame de calcul pour supercalculateur comprenant au moins une carte électronique comportant au moins un processeur, une pluralité de connecteurs et un dissipateur thermique (1) selon l'une quelconque des revendications précédentes fixé sur l'au moins une carte électronique de telle sorte que chaque connecteur soit en interface avec l'une des zones d'interfaçage (11A) dudit dissipateur thermique (1).

14. Lame de calcul selon la revendication précédente, dans laquelle les connecteurs sont de type OSFP.

15. Procédé de fabrication d'un dissipateur thermique (1) à refroidissement liquide pour une pluralité de connecteurs de lame de calcul, ledit procédé comprenant les étapes de :
- création, de préférence par usinage, d'un corps (10) de forme allongée définissant sur l'une de ses faces une surface (11) de collecte de chaleur de la pluralité de connecteurs, ledit corps (10) comprenant un port d'entrée (12) de liquide réfrigérant et un port de sortie (13) de liquide réfrigérant et étant configuré pour acheminer le liquide réfrigérant à travers un circuit de refroidissement (14) entre ledit port d'entrée (12) et ledit port de sortie (13), ladite surface (11) de collecte de chaleur comprenant une pluralité de zones d'interfaçage (11A) disposées consécutivement le long de la surface (11) de collecte de chaleur, chaque zone d'interfaçage (11A) étant configurée pour s'interfacer avec un connecteur de la pluralité de connecteurs afin d'en collecter la chaleur pour la transférer au circuit de refroidissement (14),
- création d'au moins un raidisseur (20) configuré pour être monté sur le corps (10),
- montage de l'au moins un raidisseur (20) au moins en partie le long du corps (10).
